# EUROPEAN PATENT APPLICATION

(11) **EP 2 747 162 A1**
(43) Date of publication of application: **25.06.2014**
(21) Application number: 13165093.9
(22) Date of filing: 24.04.2013
(51) Int. Cl.: H01L 51/52, H01L 27/32, H01L 51/56

(54) **Organic light-emitting diode package structure and method for forming the same**

(30) Priority: 24.12.2012 CN 201210567658
(71) Applicant: Shanghai Tianma Micro-electronics Co., Ltd., Pudong New District Shanghai 201201 (CN)
(72) Inventor: Xiong, Zhiyong, 201201 Shanghai (CN); Zhao, Bengang, 201201 Shanghai (CN); Ma, Xiaojun, 201201 Shanghai (CN)
(74) Representative: Epping - Hermann - Fischer

(57) **Abstract**

An OLED package structure (400) includes: a substrate (410), on which an organic light-emitting element (411) is provided; a cover plate (420), where a groove is annularly provided on the periphery of the inner surface of the cover plate to surround the organic light-emitting element; and a packaging adhesive (430), a portion of the packaging adhesive being located inside the groove and a portion of the packaging adhesive being exposed outside the groove, the cover plate and the substrate being adhered to each other by the packaging adhesive therebetween, so as to seal the organic light-emitting element. In the OLED package structure according to the present invention, the thickness of the spacer can be smaller, so as to eliminate a color mixture during an evaporation process and prevent a Newton ring phenomenon in the OLED package structure.

## Description

### FIELD OF THE INVENTION

The present invention relates to the field of display, and in particular to an organic light-emitting diode package structure and a method for forming the same.

### BACKGROUND OF THE INVENTION

Organic light-emitting diode (OLED) display, which is also referred to as organic electroluminescence display (OELD), is known as a most promising display technology due to its advantages such as good color contrast, active light-emitting, wide viewing angle, capability of being thinned, fast response speed and low power consumption. However, in an OLED device, it is possible for an organic light-emitting layer and an electrode to fail if they are encountered with water and oxygen, thereby the service life of the OLED device is affected greatly. Thus the OLED device generally needs to be packaged for sealing. In an early packaging method, since it is impossible to ensure a good sealing effect, typically desiccant or sheet of drier may be provided inside the OLED device. However, it has been unnecessary to provide the desiccant or sheet of drier inside the OLED device since frit was used as a packaging adhesive, as the frit is heated and melted by using a moving laser beam and can form a seal structure with good air-tightness.

However, there is a new problem for the OLED package structure using the frit as the packaging adhesive.

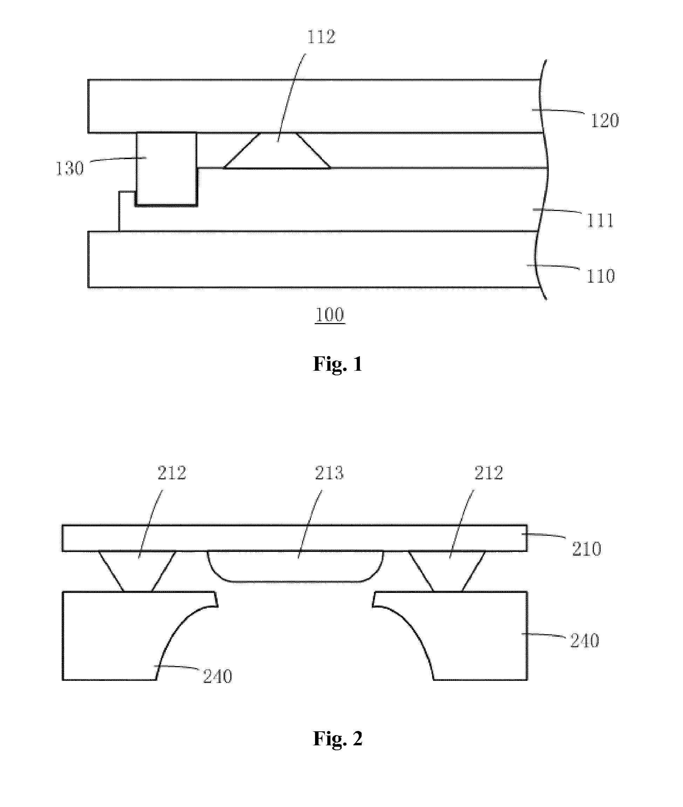

As shown in Figure 1, an existing OLED package structure 100 using the frit as the packaging adhesive includes a substrate 110, a cover plate 120 and a frit packaging adhesive 130. An organic light-emitting element 111 is formed on the substrate 110. Typically, there is a spacer 112 inside the package structure for keeping a uniform distance between the substrate 110 and the cover plate 120 of the OLED.

Generally, the spacer should not be manufactured to be too thick. This is because, as shown in Figure 2, evaporation is needed during the manufacture of the OLED. During the evaporation, a mask 240 is typically used for protection, and an organic film layer 213 (and an inorganic film layer) is formed on the substrate through an opening of the mask 240 by the evaporation. During the evaporation process, the mask 240 adjoins the spacer 212. Thus, if the spacer 212 is too thick, a shadow (i.e. unwanted evaporation materials occurring on the left side and the right side of the organic film layer 212 in Figure 2) is possible to be generated during the evaporation process. The shadow effect may cause bad situations such as color mixture of the display device.

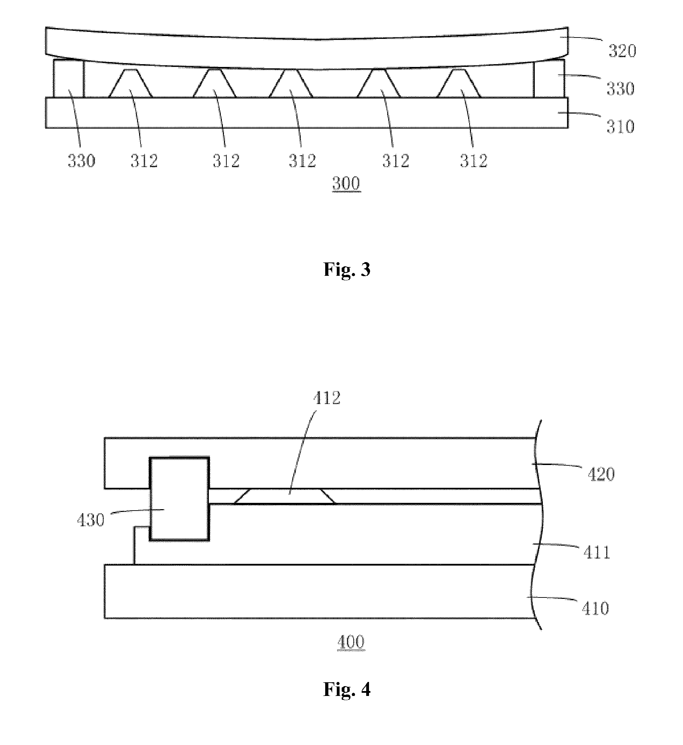

Therefore, it is typically required to manufacture a thinner spacer. Moreover, the frit used as the packaging adhesive is also required to be thinner. This is because, as shown in Figure 3, if the thickness of the frit 330 is not reduced, the frit 330 on the left side and the right side of the OLED package structure 300 is thicker and the spacers 312 in the middle are thinner, thus the cover plate 320 may be warped with a certain bend radian. In this case, a Newton ring effect which affects image quality of the finally formed display device may be generated between the cover plate 320 and the substrate 310. However, the manufactured frit 330 is impossible to be too thin due to a self limitation (the frit 330 has to be sufficiently thick to ensure packaging requirements).

### SUMMARY OF THE INVENTION

Therefore, in order to solve the color mixture and the Newton ring occurring in the OLED display device which are mentioned in the background, the present invention provides an OLED package structure, including:

a substrate, on which an organic light-emitting element is provided;

a cover plate, where a groove is annularly provided on a periphery of an inner surface of the cover plate to surround the organic light-emitting element; and

a packaging adhesive with a thickness larger than a depth of the groove, wherein a portion of the packaging adhesive is located inside the groove of the cover plate, a portion of the packaging adhesive is exposed outside the groove of the cover plate, and the cover plate and the substrate are adhered to each other by the packaging adhesive therebetween, so as to seal the organic light-emitting element.

Optionally, the packaging adhesive is frit.

Optionally, a thickness of the frit ranges from 5µm to 9µm.

Optionally, the depth of the groove ranges from 1µm to 4µm and a width of the groove ranges from 0.8µm to 2µm.

Optionally, a spacer is provided between the organic light-emitting element and the cover plate.

Optionally, the cover plate is a transparent cover plate made of a glass material or a plastic material.

Optionally, the OLED is an active matrix OLED and the organic light-emitting element is an active matrix organic light-emitting element.

The present invention further provides a method for forming an OLED package structure, including:

providing an entire substrate including multiple substrate units, on each of which an organic light-emitting element is provided;

providing an entire cover plate including multiple cover plate units, where a groove is annularly provided in an inner surface of each of the cover plate units to surround the organic light-emitting element;

forming a packaging adhesive in the groove of each of the cover plate units, where a portion of the packaging adhesive is located inside the groove of each of the cover plate units and a portion of the packaging adhesive is exposed outside the groove of each of the cover plate units;

pressing the entire cover plate and the entire substrate together, and adhering the cover plate units with the substrate units correspondingly in a manner of one to one by using the packaging adhesive to seal each organic light-emitting element; and

cutting the entire cover plate and the entire substrate which are adhered and pressed together, to obtain multiple OLED package structures.

Optionally, the packaging adhesive is frit.

Optionally, the frit is formed in the groove by using a screen printing process.

Optionally, the frit is melted by laser to adhere the cover plate units with the substrate units.

Optionally, a thickness of the frit ranges from 5µm to 9µm.

Optionally, a depth of the groove ranges from 1µm to 4µm and a width of the groove ranges from 0.8µm to 2µm.

Optionally, a spacer is provided between the organic light-emitting element and the cover plate unit.

Optionally, the entire cover plate is a transparent cover plate made of a glass material or a plastic material.

Optionally, the OLED is an active matrix OLED and the organic light-emitting element is an active matrix organic light-emitting element.

Compared with the prior art, the present invention has the following advantages:

In the OLED package structure according to the present invention, one or more grooves are annularly provided on the periphery of the inner surface of the cover plate, so that a portion of the packaging adhesive can enter into the groove(s), thereby the thickness of the spacer can be smaller to prevent the color mixture phenomenon from occurring in an evaporation process. Moreover, since a portion of the packaging adhesive can enter into the groove(s) provided around the inner surface of the cover plate, the cover plate and the substrate are parallel after being packaged, so as to prevent the Newton ring phenomenon from occurring in the OLED package structure.

### BRIEF DESCRIPTION OF THE DRAWINGS

Figure 1 is a schematic diagram illustrating an existing OLED package structure using frit as a packaging adhesive;

Figure 2 is a schematic diagram illustrating the OLED package structure illustrated in Figure 1 during an evaporation process;

Figure 3 is a schematic diagram illustrating an existing OLED package structure in which a Newton ring occurs;

Figure 4 is a schematic diagram illustrating an OLED package structure according to an embodiment of the present invention; and

Figure 5 to Figure 7 are schematic diagrams illustrating structures corresponding to steps in a method for forming an OLED package structure according to an embodiment of the present invention.

### DETAILED DESCRIPTION OF THE INVENTION

### A First Embodiment

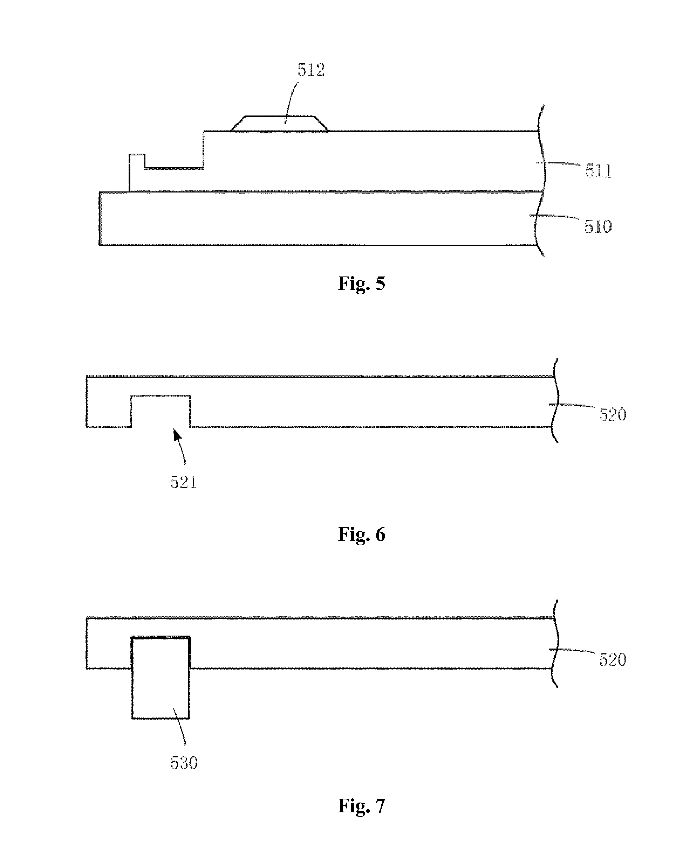

As shown in Figure 4, an OLED package structure 400 according to an embodiment is provided. The OLED package structure 400 includes a substrate 410, a cover plate 420 and a packaging adhesive 430. On the substrate 410, an organic light-emitting element 411 including an OLED and a related accessory (not shown in the Figure) is provided. One groove is annularly provided on the periphery of the inner surface of the cover plate 420 to surround the organic light-emitting element 411 (the groove is not shown in Figure 4, but it may be understood that the groove is provided at the place where the packaging adhesive 430 extends into the cover plate 420, and a groove 521 in Figure 6 can be referred to). The thickness of the packaging adhesive 430 is larger than the depth of the groove, so that a portion of the packaging adhesive 430 is located in the groove of the cover plate 420, and a portion of the packaging adhesive 430 is exposed outside the groove of the cover plate 420. The cover plate 420 and the substrate 410 are adhered to each other by the packaging adhesive 430 therebetween, so as to seal the organic light-emitting element 411.

It should be noted that, in other embodiments according to the present invention, multiple grooves may also be annularly provided on the periphery of the inner surface of the cover plate 420 as required by design. The frit is filled in each of the grooves correspondingly, and then the adhering is performed, so that the effect of sealing and adhering between the cover plate 420 and the substrate 410 is better.

In the embodiment, multiple spacers 412 (only one is shown in Figure 4) are provided between the organic light-emitting element 411 and the cover plate 420. In the OLED package structure 400 according to the embodiment, a portion of the packaging adhesive 430 is fixed in the groove of the cover plate 420. Therefore, the distance between the cover plate 420 and the substrate 410 adhered with the packaging adhesive 430 can be kept smaller with the packaging being not affected, and thus the thickness of the spacer 412 may be smaller. Since the thickness of the spacers 412 is smaller, evaporated materials at undesirable places may be eliminated during an evaporation process (referring to Figure 3 and the related content in the background) for forming the organic light-emitting element 411. That is, a shadow is avoided during the evaporation process. Thereby, a color mixture phenomenon is prevented from occurring in the OLED package structure 400. Moreover, since the thickness of the spacers 412 is just equal to the distance between the cover plate 420 and the substrate 410, in this case the spacers 412 may ensure a uniform distance between the cover plate 420 and the substrate 410, so that the Newton ring phenomenon is prevented form occurring in the entire OLED package structure 400.

In the existing design, the thickness of the spacer is typically above 2.5µm. However, in the embodiment, the thickness of the spacer 412 is much smaller and may be below 2.0µm. In the embodiment, the thickness of the spacer may be only 1.5µm or 1.0µm.

In the embodiment, the substrate 410 may be either a transparent substrate 410 or a semitransparent or nontransparent substrate 410. More preferably, the substrate 410 may be a glass substrate 410.

In the embodiment, the cover plate 420 may be a transparent cover plate. More preferably, the cover plate 420 may be a transparent cover plate made of a glass material or a plastic material. In order to be used with the packaging adhesive 430 used later, in the embodiment, the depth of the groove (referring to the groove 521 in Figure 6) provided on the cover plate 420 ranges from 1µm to 4µm and the width thereof ranges from 0.8µm to 2µm.

In the embodiment, the packaging adhesive 430 may be frit. The frit can not be manufactured thinly due to the property thereof (otherwise, the frit can not have a good sealing and adhering effect). Thereby, in the embodiment, the thickness of the frit preferably ranges from 5µm to 9µm. With a thickness in such range, a portion of the frit may extend into the groove (referring to the groove 521 in Figure 6) of the cover plate 420 and another portion of the frit is exposed outside the groove for being adhered onto the substrate 410. It should be noted that, other packaging adhesives which are capable of ensuring good sealing for the OLED package structure 400 may also be applicable in other embodiments according to the present invention.

Preferably, in the embodiment, the OLED is an active matrix OLED and the organic light-emitting element 411 is an active matrix organic light-emitting element 411. Thus the formed OLED package structure 400 is an active matrix OLED package structure.

### A Second Embodiment

The embodiment provides a method for forming an OLED package structure, including Step S1 to Step S5. It should be noted that, in the embodiment, the steps are named as S1 to S5 just for distinguishing the steps conveniently and not for limiting the sequencing of the steps. In different embodiments according to the present invention, the sequencing of the steps may be adjusted according to a process adjustment. Steps S1 to S5 will be described correspondingly in conjunction with Figure 4 to Figure 7 as follows respectively. Practically, the OLED package structure 400 as shown in Figure 4 is finally formed with Steps S1 to S5 (corresponding to structures shown in Figure 5 to Figure 7) in the embodiment.

In Step S1, an entire substrate including multiple substrate units is provided, on each of which an organic light-emitting element is provided.

With reference to Figure 5, the entire substrate 510 according to the embodiment includes multiple substrate units. As shown in Figure 5, in the embodiment, only a portion of one substrate unit of the entire substrate 510 is shown for convenience of illustration and explaining. On the substrate unit, an organic light-emitting element 511 including an OLED and other related component is provided. A process for forming the organic light-emitting element 511 on the entire substrate 510 is well known and will not be described herein.

Still referring to Figure 5, the thickness of the spacer in the existing design is typically above 2.5µm. In the embodiment, a spacer 512 is provided on the organic light-emitting element 511 and the thickness of the spacer 512 is much smaller than that in the existing design and may be below 2.0µm. In the embodiment, the thickness of the spacer 512 may be only 1.5µm or 1.0µm.

In Step S2, an entire cover plate is provided. The entire cover plate includes multiple cover plate units. One or more grooves are annularly provided in the inner surface of each of the cover plate units to surround the organic light-emitting element.

In the embodiment, the entire cover plate 520 (referring to Figure 6) corresponding to the entire substrate 510 is provided. The entire cover plate 520 includes multiple cover plate units. Similarly, as shown in Figure 6, only a portion of one cover plate unit of the entire cover plate 520 is shown for convenience of illustration and explaining. The cover plate unit matches with the above-mentioned substrate unit correspondingly. That is to say, one cover plate unit just closes over one substrate unit correspondingly. One groove 521 is annularly provided in the inner surface of each of the cover plate units to surround the organic light-emitting element. It should be noted that, in other embodiments of the invention, according to a design requirement, multiple grooves may also be annularly provided on the periphery of the inner surface of one cover plate unit, so as to improve the packaging effect.

In the embodiment, the entire cover plate 520 is preferably a transparent cover plate. More preferably, the entire cover plate 520 is a transparent cover plate made of a glass material or a plastic material. The depth of the groove 521 may range from 1µm to 4µm and the width thereof may range from 0.8µm to 2µm, so that a portion of a packaging adhesive (a packaging adhesive 530 in Figure 7 may be referred to) can fill in the groove 521later.

In Step S3, the packaging adhesive is formed in the groove of the cover plate unit. A portion of the packaging adhesive is located inside the groove of the cover plate and a portion of the packaging adhesive is exposed outside the groove of the cover plate.

Referring to Figure 7, in the embodiment, the packaging adhesive 530 is preferably frit. The frit may be formed in the groove 521 by using a screen printing process. Moreover, the thickness of the frit packaging adhesive 530 may range from 5µm to 9µm to fit the above-mentioned size of the groove 521 (the depth of the groove 521 ranges from 1µm to 4µm and the width thereof ranges from 0.8µm to 2µm). It should be noted that other packaging adhesives which are capable of ensuring good sealing for the OLED package structure may also be applicable in other embodiments according to the present invention.

In Step S4, the entire cover plate and the entire substrate are pressing together, and the cover plate units are adhered with the substrate units correspondingly in a manner of one to one by using the packaging adhesive, so as to seal each organic light-emitting element.

According to the embodiment, in Step S4, the purpose is to form multiple seal structure units as a whole. Therefore, the entire cover plate 520 and the entire substrate 510 are pressed together with the cover plate units being adhered with the substrate units in a manner of one to one by using the packaging adhesive 530, and each organic light-emitting element 511 is sealed. Although the formed entire OLED package structure is not shown in the figure, the structure in Figure 4 may be referred to. Figure 4 may be regarded as a schematic diagram illustrating a portion of one unit of the OLED package structures formed as a whole. In the embodiment, the frit may be melted by laser to adhere the cover plate units with the substrate units.

In Step S5, the entire cover plate and the entire substrate which are adhered and pressed together are cut, to obtain multiple OLED package structures.

Finally, in the embodiment, the OLED package structures formed as a whole are cut into individual OLED package structures, that is, the entire cover plate and the entire substrate which are adhered and pressed together are cut, to obtain multiple OLED package structures. For the OLED package structure, the OLED package structure 400 shown in Figure 4 may be referred to. Preferably, in the embodiment, the OLED is an active matrix OLED and the organic light-emitting element is an active matrix organic light-emitting element, thus the finally formed OLED package structure is an active matrix OLED package structure.

What are described above are only specific embodiments of the present invention and the purpose is to make the spirit of the present invention be better understood by those skilled in the art. However, the scope of protection of the present invention is not limited thereto. Changes may be made to the embodiments of the present invention by those skilled in the art in light of the spirit of the present invention without deviation from the scope of protection of the present invention.

## Claims

1. An organic light-emitting diode package structure, comprising:
a substrate, on which an organic light-emitting element is provided;
a cover plate, wherein a groove is annularly provided on a periphery of an inner surface of the cover plate to surround the organic light-emitting element; and
a packaging adhesive with a thickness larger than a depth of the groove, wherein a portion of the packaging adhesive is located inside the groove of the cover plate, a portion of the packaging adhesive is exposed outside the groove of the cover plate, and the cover plate and the substrate are adhered to each other by the packaging adhesive therebetween, so as to seal the organic light-emitting element.

2. The organic light-emitting diode package structure according to claim 1, wherein the packaging adhesive is frit.

3. The organic light-emitting diode package structure according to claim 2, wherein a thickness of the frit ranges from 5µm to 9µm.

4. The organic light-emitting diode package structure according to one of the previous claims, wherein the depth of the groove ranges from 1µm to 4µm and a width of the groove ranges from 0.8µm to 2µm.

5. The organic light-emitting diode package structure according to one of the previous claims, wherein a spacer is provided between the organic light-emitting element and the cover plate.

6. The organic light-emitting diode package structure according to one of the previous claims, wherein the cover plate is a transparent cover plate made of a glass material or a plastic material.

7. The organic light-emitting diode package structure according to one of the previous claims, wherein the organic light-emitting diode is an active matrix organic light-emitting diode and the organic light-emitting element is an active matrix organic light-emitting element.

8. A method for forming an organic light-emitting diode package structure, comprising:
providing an entire substrate comprising a plurality of substrate units, on each of which an organic light-emitting element is provided;
providing an entire cover plate comprising a plurality of cover plate units, wherein a groove is annularly provided in an inner surface of each of the cover plate units to surround the organic light-emitting element;
forming a packaging adhesive in the groove of each of the cover plate units, wherein a portion of the packaging adhesive is located inside the groove of each of the cover plate units and a portion of the packaging adhesive is exposed outside the groove of each of the cover plate units;
pressing the entire cover plate and the entire substrate together, and adhering the cover plate units with the substrate units in a manner of one to one by using the packaging adhesive to seal each organic light-emitting element; and
cutting the entire cover plate and the entire substrate which are adhered and pressed together, to obtain a plurality of organic light-emitting diode package structures.

9. The method for forming the organic light-emitting diode package structure according to claim 8, wherein the packaging adhesive is frit, and the entire cover plate is a transparent cover plate made of a glass material or a plastic material.

10. The method for forming the organic light-emitting diode package structure according to claim 9, wherein the frit is formed in the groove by using a screen printing process.

11. The method for forming the organic light-emitting diode package structure according to one of claims 9 or 10, wherein the frit is melted by laser to adhere the cover plate units with the substrate units.

12. The method for forming the organic light-emitting diode package structure according to one of claims 9 to 11, wherein a thickness of the frit ranges from 5µm to 9µm.

13. The method for forming the organic light-emitting diode package structure according to one of claims 8 to 12, wherein a depth of the groove ranges from 1µm to 4µm and a width of the groove ranges from 0.8µm to 2µm.

14. The method for forming the organic light-emitting diode package structure according to one of claims 8 to 13, wherein a spacer is provided between the organic light-emitting element and the cover plate unit.

15. The method for forming the organic light-emitting diode package structure according to one of claims 8 to 14, wherein the organic light-emitting diode is an active matrix organic light-emitting diode and the organic light-emitting element is an active matrix organic light-emitting element.
